(19) Europäisches Patentamt / European Patent Office / Office européen des brevets

(11) EP 2 071 616 B1

(12) **EUROPEAN PATENT SPECIFICATION**

(45) Date of publication and mention of the grant of the patent:
**21.11.2018 Bulletin 2018/47**

(21) Application number: **07806727.9**

(22) Date of filing: **05.09.2007**

(51) Int Cl.:
***H01L 21/316*** *(2006.01)* ***C08G 77/62*** *(2006.01)*
***C09D 183/16*** *(2006.01)* ***H01L 21/312*** *(2006.01)*
***H01L 21/76*** *(2006.01)*

(86) International application number:
**PCT/JP2007/067284**

(87) International publication number:
**WO 2008/029834 (13.03.2008 Gazette 2008/11)**

(54) **COMPOSITION FOR FORMING SILICEOUS FILM AND PROCESS FOR PRODUCING SILICEOUS FILM FROM THE SAME**

ZUSAMMENSETZUNG ZUR BILDUNG VON KIESELHALTIGEM FILM UND PROZESS ZUR HERSTELLUNG EINES KIESELHALTIGEN FILMS DARAUS

COMPOSITION POUR FORMER UN FILM SILICEUX ET PROCÉDÉ DE PRODUCTION DE FILM SILICEUX À PARTIR DE CELLE-CI

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **08.09.2006 JP 2006244611**
**28.02.2007 JP 2007049995**

(43) Date of publication of application:
**17.06.2009 Bulletin 2009/25**

(73) Proprietor: **Merck Patent GmbH**
**64293 Darmstadt (DE)**

(72) Inventor: **HAYASHI, Masanobu**
**Kakegawa-shi**
**Shizuoka 437-1412 (JP)**

(74) Representative: **Rippel, Hans Christoph**
**Isenbruck Bösl Hörschler LLP**
**Eastsite One**
**Seckenheimer Landstrasse 4**
**68163 Mannheim (DE)**

(56) References cited:
**EP-A2- 0 237 199** **JP-A- 2003 171 383**
**JP-A- 2006 054 353** **US-A- 4 840 778**
**US-A1- 2005 145 177**

- **CHEN X ET AL: "Annealing and oxidation of silicon oxide films prepared by plasma-enhanced chemical vapor deposition", JOURNAL OF APPLIED PHYSICS, AMERICAN INSTITUTE OF PHYSICS, US, vol. 97, no. 1, 16 December 2004 (2004-12-16), pages 14913-014913, XP012069283, ISSN: 0021-8979**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

### TECHNICAL FIELD

The present invention relates to a composition for forming a siliceous film in an electronic device, and also relates to a siliceous film-formation process employing the same. In detail, the present invention relates to a polysilazane-containing composition for forming a shallow trench isolation structure, which is provided in an electronic device for the purpose of insulation in fabrication of electronic devices such as semiconductor elements; and the present invention also relates to a process employing the same for forming a siliceous film.

### BACKGROUD ART

In an electronic device such as a semiconductor element, semiconductor parts such as transistor, resistance and the like are arranged on a substrate. Since those parts must be electrically insulated from each other, it is necessary to form an area separating them. This area is referred to as an "isolation area". Hitherto, the isolation area has been generally provided by forming an insulating film selectively on the surface of the semiconductor substrate.

Meanwhile, recently in the field of electronic device technology, the density and the integration degree have been more and more increased. According as the density and the integration degree are becoming higher, it is getting more difficult to form an isolation structure having fineness corresponding to the required integration degree. It is, therefore, desired to provide a new isolation structure satisfying the required fineness. As one of the isolation structures capable of satisfying the requirement, a trench isolation structure is proposed. The trench isolation structure is fabricated by forming fine trenches on a semiconductor substrate and then filling the trenches with insulating material so as to electrically separate the part positioned on one side from that on the other side of each trench. The structure thus electrically separating the parts can reduce the isolation area, as compared with the conventional, and accordingly, is effective in achieving the integration degree required in these days.

For fabricating the trench isolation structure, a CVD method or a high density plasma CVD method, for example, can be used (see, for example, Patent document 1). However, if the trenches having fineness required in these days, for example, the trenches of 100 nm or less are filled according to those methods, some voids often exist in the filled trenches. These structural defects are liable to deteriorate the physical strength of the substrate and/or to impair the insulation characteristics.

In order to favorably fill the trenches in, it is proposed (for example, in Patent document 1) to fill the trenches by coating the substrate with a solution of silicon hydroxide and then heating the applied solution to convert the silicon hydroxide into silicon dioxide. However, in this method, when the silicon hydroxide is converted into silicon dioxide, the volume shrinks and often forms cracks.

For avoiding the cracks, it is also proposed (for example, in Patent documents 1 and 2) to use polysilazane in place of the silicon hydroxide in the above method. When the polysilazane is converted into silicon dioxide, its volume shrinkage is less than that of silicon hydroxide. Accordingly, the cracks formed by the volume shrinkage can be avoided. This method comprises the steps of coating a composition containing polysilazane to fill the trenches in, and then treating the coated composition under an oxidizing atmosphere to fabricate a trench isolation structure made of highly pure and dense silicon dioxide. Since the composition sufficiently fills into the trenches, this method has the advantage of forming few voids. However, the present inventors have found that, if the trench isolation structure is intended to be formed by this method, there is a problem that the film of the coated composition is etched unevenly since the etching rate at the surface is different from that in the trenches. The reason of this is presumed to be as follows. When the polysilazane is converted into silicon dioxide to form a siliceous film, the reaction conditions such as oxygen supply at the surface are delicately different from those in the trenches. Thus, the characteristics of the resultant siliceous film in the trenches are different from those out of the trenches, and also they depend upon the depth in the trenches. As a result, it is presumed that the siliceous film in the trenches have a low density to cause the above problem. In particular, the above problem is so serious in a low temperature treatment, which is often required by restrictions on the device design and/or on the process design, that the film in trenches having high aspect ratios is etched at higher etching rates. Since semiconductor devices have been getting more and more densely integrated in these days, the position-dependent etching rate becomes a more serious problem.

[Patent document 1] Japanese Patent No. 3178412 (paragraph: 0005 to 0016)
[Patent document 2] Japanese Patent Laid-Open No. 2001-308090
[Patent document 3] Japanese Patent Laid-Open No. 2005-120029

EP 0 237 199 A2 discloses a composition for the formation of polysiloxazane fibers.

US 4,870,778 A discloses a siliceous film-forming composition containing a polysilazane compound which is

obtained by ammonolysis of specific halosilane compounds.

WO 03/045959 and Chen X. Etal., Journal of Applied Physis, American Institute of Physics 97 (2004) 14913 disclose siliceous films.

DISCLOSURE OF INVENTION

PROBLEM TO BE SOLVED BY THE INVENTION

In consideration of the aforementioned problem, it is an objective of the present invention to provide a composition for forming a siliceous film dense and homogeneous even in fine trenches.

MEANS FOR SOLVING PROBLEM

The present invention resides in a siliceous film-forming composition containing
a polysilazane compound which comprises a quaternary silicon atom the four bonds of which are all connected to non-hydrogen atoms, and which is obtained by co-ammonolysis of one or a combination of two or more halosilane compounds represented by the formula (A):

$$X\text{-}(SiY_2)_n\text{-}X \qquad (A)$$

in which X is a halogen, Y is a halogen, provided that each X and each Y may be the same or different from each other, and n is a number of 2 or more; and
a solvent capable of dissolving said polysilazane compound.

The present invention also resides in a siliceous film-formation process comprising
a coating step in which a concave-convex surface of a silicon substrate is coated with the above siliceous film-forming composition, and
a hardening step in which the coated substrate is subjected to heat-treatment at a temperature of less than 1000°C under an oxygen atmosphere or under an oxidizing atmosphere containing water vapor, so that said composition is converted into silicon dioxide in the form of a film.

Further disclosed is a siliceous film formed by the above siliceous film-formation process, characterized by having a thickness shrinkage ratio of 95% or less based on the thickness shrinkage ratio of perhydropolysilazane.

EFFECT OF THE INVENTION

The present invention provides a siliceous film-forming composition from which a siliceous film having a small thickness shrinkage can be obtained. If a trench isolation structure is fabricated from this film-forming composition, the siliceous film can be formed homogeneously even at deep places in very narrow trenches. Accordingly, even in an electric device needed to have a high aspect ratio, a high-quality trench isolation structure can be fabricated.

BEST MODE FOR CARRYING OUT THE INVENTION

<u>Siliceous film-forming composition</u>

The siliceous film-forming composition according the present invention contains a quaternary silicon atom-containing polysilazane compound obtained by co-ammonolysis of one or a combination of two or more halosilane compounds represented by the formula (A):

$$X\text{-}(SiY_2)_n\text{-}X \qquad (A)$$

(in which X is a halogen, Y is a halogen, provided that each X and each Y may be the same or different from each other, and n is a number of 2 or more); and a solvent capable of dissolving said polysilazane compound therein. Here, the "quaternary silicon atom" means a silicon atom the four bonds of which are all connected to non-hydrogen atoms, namely, a silicon atom not connected to a hydrogen atom with any of the four bonds thereof. The non-hydrogen atom connected to the bond of the quaternary silicon atom may be any atom other than hydrogen. Examples of the non-hydrogen atom include nitrogen or silicon in a silazane group, carbon in a hydrocarbon group, oxygen in a siloxy group, halogens, oxygen in a hydroxyl group, and nitrogen in an amino group. It is preferred that the four bonds of the silicon atom be connected to nitrogen atoms, particularly, in silazane groups. Such silicon atom can be detected by means of NMR, such as DEPT-$^{29}$Si-NMR.

The halosilane compound preferably contains a silicon atom not connected to a hydrogen atom in order that the polysilazane compound obtained by co-ammonolysis can contain a quaternary silicon atom. This is because, if the silicon atom before the co-ammonolysis is connected only to other adjacent silicon atoms and/or to halogen atoms, it becomes a quaternary silicon atom connected only to other silicon atoms which still remain from before the co-ammonolysis or which are included in silazane groups formed by the co-ammonolysis. However, even if the silicon atom before the co-ammonolysis is connected to a hydrogen atom, it sometimes becomes a quaternary silicon atom in the case where a halosilane compound represented by the above formula (A), in which two or more Si atoms are continuously connected, is employed. The reason of this is yet to be unknown. In spite of that, the polysilazane compound containing a quaternary silicon atom can be obtained and used in a siliceous film-forming composition according the present invention.

In a known process in which a composition is coated on a substrate or the like and then fired to form a siliceous film, the composition normally contains a silane compound or a silazane compound as a material of the siliceous film. These compounds contain Si-O bonds or Si-N bonds. In contrast, the polysilazane compound included in the composition according to the present invention contains a quaternary silicon atom participating in a Si-N bond. In the present invention, the polysilazane compound is oxidized to be converted into silicon dioxide. The present inventors have found that a film thus formed from the polysilazane compound containing a quaternary silicon atom has a smaller thickness shrinkage ratio than a film formed from the conventional composition containing a silane compound or a silazane compound. The reason of this is yet to be revealed clearly, but is presumed to be as follows. Since the composition of the present invention contains many quaternary silicon atoms, the polysilazane compound has a three-dimensionally bulky structure. Accordingly, even if Si-N-Si bonds are oxidized to be converted into Si-O-Si bonds and consequently the bonding distances are shortened, the volume shrinks in a small degree.

There is no particular restriction on the molecular weight of the polysilazane compound, but it is generally 1500 or more, preferably in the range of 2000 to 3000.

As a material of the above co-ammonolysis reaction, dichloromonosilane is also usable. For example, the polysilazane compound used in the composition of the present invention can be obtained by co-ammonolysis of dichloromonosilane in combination with a halosilane compound represented by the formula (A):

$$X\text{-}(SiY_2)_n\text{-}X \qquad (A)$$

(in which X, Y and n are individually the same as defined above). Here, two or more halosilane compounds of the formula (A) can be used in combination. The dichloromonosilane in combination with a halosilane compound of the formula (A) or with two or more halosilane compounds of the formula (A) having different n numbers can be made to undergo the co-ammonolysis to prepare a polysilazane compound, which can be used in the composition according to the present invention.

Two or more polysilazane compounds can be used in combination, if necessary.

The siliceous film-forming composition according to the present invention contains a solvent as well as the above polysilazane compound. As the solvent, any solvent capable of dissolving the polysilazane compound can be employed. Examples of the solvent include: (a) aromatic compounds such as benzene, toluene, xylene, ethylbenzene, diethylbenzene, trimethylbenzene and triethylbenzene; (b) saturated aliphatic hydrocarbons such as n-pentane, i-pentane, n-hexane, i-hexane, n-heptane, i-heptane, n-octane, i-octane, n-nonane, i-nonane, n-decane, and i-decane; (c) saturated cyclic hydrocarbons such as cyclohexane, decahydronaphthalene, ethylcyclohexane, methylcyclohexane, and p-menthane; (d) unsaturated cyclic hydrocarbons such as cyclohexene, and dipentene (limonene); (e) ethers such as dipropyl ether, dibutyl ether, and anisole; (f) esters such as n-butyl acetate, i-butyl acetate, n-amyl acetate, and i-amyl acetate; and (g) ketones such as methyl i-butyl ketone.

For the purposes of improving film-formability in coating the composition and of controlling the shrinkage in converting Si-N-Si into Si-O-Si, the siliceous film-forming composition of the present invention can contain another polysilazane compound in addition to the quaternary silicon atom-containing polysilazane compound defined above. The film-formability of the composition and the density of the resultant siliceous film are apt to be improved by mixing the aforementioned quaternary silicon atom-containing polysilazane compound with another polysilazane compound. Accordingly, they are preferably mixed to use. The additional polysilazane compound other than the quaternary silicon atom-containing one can be selected from known compounds, and is, for example, represented by the following formula (I):

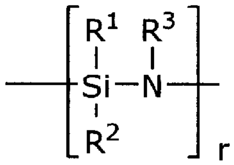

(I)

in which each of $R^1$ to $R^3$ is independently hydrogen, an alkyl group containing 1 to 3 carbon atoms, or a substituted or non-substituted phenyl group; and r is an integer indicating polymerization degree.

The additional polysilazane compound is not restricted to the above compound of the formula (I), and can be desirably selected from known compounds according to the aimed use.

In the present invention, the ratio between the additional polysilazane compound and the quaternary silicon atom-containing one is not particularly restricted. However, the quaternary silicon atom-containing polysilazane compound is contained in an amount of generally 5 to 40 wt.%, preferably 10 to 30 wt.%, based on the total amount of all the polysilazane compounds.

The siliceous film-forming composition according to the present invention is characterized in that the thickness shrinkage of the siliceous film formed from the composition is reduced by quaternary silicon atoms in the polysilazane compound contained therein. Accordingly, if the quaternary silicon atoms are contained in a relatively large amount, the shrinkage in converting Si-N-Si into Si-O-Si is apt to be reduced. Therefore, the number of the quaternary silicon atoms contained the composition is preferably 30 atom% or more, further preferably 50 atom% or more, based on the number of all the silicon atoms contained therein. On the other hand, however, the composition preferably contains a certain amount of tertiary or lower silicon atoms in order to control the shrinkage in converting Si-N-Si into Si-O-Si and thereby to keep the film shrinkage and the film properties properly. The content of the tertiary or lower silicon atoms is preferably 0.1 atom% or more. For increasing the content of the tertiary or lower silicon atoms, the aforementioned polysilazane compound containing many quaternary silicon atoms can be mixed with another polysilazane compound, which may contain quaternary silicon atoms or may be represented by the formula (II).

There is no particular restriction on the solid content of the siliceous film-forming composition. However, the solid content is in the range of generally 5 to 30 wt.%, preferably 20 to 30 wt.% so that the resultant film can have sufficient and even thickness. The solid content of the composition must be properly controlled in consideration of various conditions such as the coating method and the aimed thickness of the resultant film.

Siliceous film-formation process

According to the siliceous film-formation process of the present invention, a homogeneous film containing no void can be form on a concavo-convex surface of a silicon substrate. It is, therefore, possible to form a flat insulation (pre-metal dielectric) film on a transistor part or a capacitor part of an electric device. Further, it is also possible to form a siliceous film with which trenches previously provided on a substrate can be filled to fabricate a trench isolation structure. In the following description, the present invention is explained in the case where it applied for fabricating a trench isolation structure.

The siliceous film-formation process according to the present invention comprises
a coating step in which a concavo-convex surface of a silicon substrate is coated with a siliceous film-forming composition containing a polysilazane compound obtained by co-ammonolysis of one or a combination of two or more halosilane compounds represented by the formula (A):

$$X\text{-}(SiY_2)_n\text{-}X \qquad (A)$$

(in which X is a halogen, Y is a halogen, provided that each X and each Y may be the same or different from each other, and n is a number of 2 or more), and a solvent capable of dissolving said polysilazane compound; and
a hardening step in which the coated substrate is subjected to heat-treatment at a temperature of less than 1000°C under an oxygen atmosphere or under an oxidizing atmosphere containing water vapor, so that said composition is converted into silicon dioxide in the form of a film.

The above polysilazane compound is preferably obtained by co-ammonolysis of dichloromonosilane in combination with a halosilane compound represented by the formula (A):

$$X\text{-}(SiY_2)_n\text{-}X \qquad (A)$$

(in which X, Y and n are individually the same as defined above). Here, two or more halosilane compounds of the formula (A) can be used in combination. The dichloromonosilane in combination with a halosilane compound of the formula (A)

or with two or more halosilane compounds of the formula (A) having different n numbers can be made to undergo the co-ammonolysis to prepare a polysilazane compound, which can be used in the process.

Two or more polysilazane compounds can be used in combination, if necessary.

(A) Coating step

The siliceous film-forming composition according to the present invention is suitable for fabricating a trench isolation structure on a substrate. Accordingly, the substrate on which the trench isolation structure is to be fabricated has concave-convex suitable for forming the structure. Thus, in the siliceous film-formation process of the present invention, a concave-convex silicon substrate is used. Particularly for fabricating the trench isolation structure, a silicon substrate provided with a desired trench pattern formed thereon is employed. The trenches may be formed by any method. For example, they are formed in the manners described in Patent documents 1 and 2. The process for forming the trenches is concretely explained below.

First, a film of silicon dioxide is formed on a surface of a silicon substrate according to, for example, a thermal oxidization method. The thickness of the formed silicon dioxide film is generally in the range of 5 to 30 nm.

If necessary, a silicon nitride film is further formed on the above-formed silicon dioxide film according to, for example, a reduced-pressure CVD method. The silicon nitride film serves as a mask in the etching step performed later or as a stop layer in the below-described polishing step. The silicon nitride film, if formed, generally has a thickness of 100 to 400 nm.

On the silicon dioxide film or the silicon nitride film formed thereon, a photoresist is coated. After dried and hardened, if necessary, the coated photoresist film is exposed to light in a desired pattern, and then developed to form the pattern. The exposure can be performed in any manner such as mask exposure or scanning exposure. Also, the photoresist can be desirably selected in consideration of resolution or the like.

While the thus-patterned photoresist film is used as a mask, the silicon nitride film and the silicon dioxide film provided thereunder are etched in order to form the aimed pattern on the silicon nitride film and the silicon dioxide film.

Thereafter, while the pattern thus formed on the silicon nitride film and the silicon dioxide film is used as a mask, the silicon substrate is subjected to dry-etching. Thus, trenches of the trench isolation structure are formed.

The width of the formed trenches is determined by the pattern having been transferred onto the photoresist film in the exposure. The width of trenches formed in a semiconductor device depends on what the device is used for, and is generally 0.02 to 10 $\mu$m, preferably 0.05 to 5 $\mu$m. The trenches have a depth in the range of 200 to 1000 nm, preferably 300 to 700 nm. According to the present invention, narrower and deeper trenches can be homogeneously filled in, as compared with conventional methods. The process of the present invention is, therefore, suitable for fabricating a narrower and deeper trench isolation structure. By the use of a conventional siliceous film-forming composition and of a known siliceous film-formation process, it is particularly difficult to form a siliceous film homogeneous even at the bottoms of deep trenches. In contrast, however, the siliceous film can be formed homogeneously even in the trenches if the siliceous film-forming composition of the present invention is used to fabricate a trench isolation structure in which the trenches have, for example, a width of generally 0.5 $\mu$m or less, preferably 0.1 $\mu$m or less, and also have an aspect ratio of 5 or more.

Thereafter, on the thus prepared silicon substrate, the above siliceous film-forming composition as source of a siliceous film is coated to form a film of the composition.

The siliceous film-forming composition can be coated on the substrate by a desired coating method. Examples of the coating methods include spin coat, curtain coat, and dip coat. In consideration of planarity of the coated composition film, spin coat is particularly preferred.

The coated composition film has a thickness of generally 10 to 1000 nm, preferably 50 to 800 nm, so that the trenches can be satisfyingly filled with the coated siliceous film-forming composition and, at the same time, so that the film of the coated composition can have a flat surface.

The coating conditions depend upon the concentration of the composition, the solvent thereof, the coating method and the like. By way of example, the conditions in spin-coating are described below.

Nowadays, in order to improve the production yield, devices are often formed on large substrates. In view of that, it is preferred to employ a spin-coating process comprising plural steps so that a film of the coated composition can be homogeneously formed on an 8-inch or larger substrate.

First, the composition in an amount of 0.5 to 20 cc is dropped onto a substrate at the center and at a few other places so that a film of the dropped composition can be homogeneously formed on the whole substrate surface.

The substrate is then spun at a relatively low rotation speed, for example, of 50 to 500 rpm for 0.5 to 10 seconds so that the dropped composition can be spread on the whole substrate surface (pre-spin).

The substrate is further spun at a relatively high rotation speed, for example, of 500 to 4500 rpm for 0.5 to 800 seconds so that the dropped composition film can have a desired thickness (main spin).

The substrate is furthermore spun at a rotation speed higher than the rotation speed of main spin by 500 rpm

or more, for example, at a rate of 1000 to 5000 rpm for 5 to 300 seconds so that the composition film at the edge of the silicon substrate can be prevented from rising and so that the solvent in the composition film can be evaporated as much as possible (final spin).

The above coating conditions are properly adjusted in consideration of the size of the substrate, the performance of the aimed semiconductor device, and the like.

(B) Hardening step

The coated composition is subjected to the pre-bake step (described below in detail), if necessary, and then heated to convert the film of the coated polysilazane into a siliceous film and thereby to harden the film. Generally, the substrate is heated in a hardening furnace.

The hardening step is preferably carried out in a hardening furnace or on a hot-plate under inert gas or oxygen atmosphere containing water vapor. The water vapor is important for sufficiently converting the film of the silicon-containing compound or the silicon-containing polymer and, if present, the polysilazane compound into a siliceous (i.e., silicon dioxide) film. The water vapor content is preferably 30% or more, further preferably 50% or more, most preferably 70% or more. It is particularly preferred that the water vapor content be 80% or more since the organic compound is smoothly converted into the siliceous film and consequently defects such as voids are less formed to improve the properties of the siliceous film. Examples of the inert gas usable as the atmospheric gas include nitrogen, argon, and helium.

The hardening temperature depends upon various conditions such as the components of the siliceous film-forming composition and the combination of the steps. However, at a high temperature, the film of the silicon-containing compound, the silicon-containing polymer and the polysilazane compound will be rapidly converted into a siliceous film. On the other hand, at a low temperature, the silicon substrate is apt to less suffer from oxidization and the crystal structure thereof is apt to change slightly, and accordingly deterioration of the properties of the device are limited. In consideration of this, the hardening step is carried out at a temperature of normally 1000°C or lower, preferably 400 to 700°C. The heating rate to the aimed temperature is generally 1 to 100°C/minute, and the aimed temperature for hardening is kept for generally 1 minute to 10 hours, preferably 15 minutes to 3 hours. If necessary, the temperature and atmosphere for hardening can be changed step-by-step.

The polysilazane compound is thus heated and converted into silicon dioxide to form a siliceous film. If the siliceous film is formed from a conventional composition containing only a known polysilazane compound, the thickness shrinkage ratio is generally in the range of 15 to 20%. In contrast, if the siliceous film is formed from the siliceous film-forming composition of the present invention containing the polysilazane compound having a quaternary silicon atom in its structure, the thickness shrinkage ratio is 10% or less. The reason of this is presumed to be as follows. Since having a quaternary silicon atom, the polysilazane compound has such a three-dimensionally bulky structure that the volume shrinks in a small degree when Si-N-Si bonds are converted into Si-O-Si bonds. As a result, the formed siliceous film shows small thickness shrinkage.

The thickness shrinkage ratio of the siliceous film is conveniently evaluated in terms of a relative value rather than an absolute value, since the measurement thereof is susceptible to even a small fluctuation of the measuring conditions. As the standard of this relative evaluation, the thickness shrinkage ratio of a siliceous film formed from a composition containing essentially pure perhydropolysilazane can be employed. In that case, the siliceous film formed from the siliceous film-forming composition of the present invention has a relative thickness shrinkage ratio of generally 95% or less, preferably 92% or less, provided that the standard thickness shrinkage ratio is regarded as 100%.

In the present invention, the "thickness shrinkage ratio" indicates how the thickness shrinks between before and after the heating treatment for converting the coated composition into the silicon dioxide film. In the case where the siliceous film is formed on a silicon wafer, the thickness shrinkage ratio X can be practically obtained by measuring the thickness before and after the heat-treatment for converting the coated siliceous film-forming composition into the silicon dioxide film and then calculating from the measured values according to the following formula:

$$X = [\{(thk)_0 - (thk)\}/(thk)_0] \times 100$$

in which $(thk)_0$ is a thickness before the heat-treatment, and (thk) is a thickness after the heat-treatment. The thicknesses can be measured by means of an ellipsometer or the like.

In the trench isolation structure-fabrication process according to the present invention, the aforementioned steps are indispensable. However, if necessary, the following optional steps can be carried out in combination. The optional steps are described below.

(a) Pre-bake step

Before the hardening step, the substrate coated with the siliceous film-forming composition may be subjected to pre-bake treatment. This step is carried out for the purposes of removing the solvent completely from the coated composition film and of preliminarily hardening the composition film. The pre-bake treatment is preferably carried out particularly in the trench isolation structure-fabrication process according to the present invention, in which the composition containing the quaternary silicon atom-containing polysilazane compound is employed, since the resultant siliceous film is improved in density.

In the pre-bake step, the substrate is normally heated at an essentially constant temperature. However, the temperature in the pre-bake step is preferably controlled to be elevated gradually so as to prevent the coated composition film from shrinking during hardening and thereby to prevent the film from denting into the trenches and/or to prevent voids from forming in the trenches of the trench isolation structure. The temperature in the pre-bake step is in the range of normally 50 to 400°C, preferably 100 to 300°C. The substrate is pre-baked generally for 10 seconds to 30 minutes, preferably for 30 seconds to 10 minutes.

For gradually elevating the temperature in the pre-bake step, the atmosphere where the substrate is placed may be step-by-step or continuously heated. In order to remove the solvent from the coated composition film, the highest temperature in the pre-bake step is generally higher than the boiling point of the solvent used in the siliceous film-forming composition.

In the case where the pre-bake step is carried out in the process of the present invention, the substrate heated in the pre-bake step is preferably subjected immediately to the hardening step before it is cooled. Preferably, the temperature of the substrate to be subjected to the hardening step is not lower than 50°C and not higher than the highest temperature in the pre-bake step. The substrate after subjected to the pre-bake step is immediately subjected to the hardening step before it is cooled, and thereby the energy and time for heating the substrate again can be saved.

(b) Polishing step

After the hardening step, unnecessary parts of the hardened siliceous film are preferably removed. In the polishing step, the siliceous film on the substrate-surface is removed by polishing. The polishing step may be carried out after the hardening step or immediately after the pre-bake step if the pre-bake step is performed.

The polishing step is performed according to chemical mechanical polishing (hereinafter, referred to as "CMP") process. The CMP process can be carried out by use of normal abrasives and abrasive apparatus. Examples of the abrasives include silica, alumina, ceria, and aqueous suspension dispersing those and, if necessary, other abrasives. The abrasive apparatus is, for example, a commercially available normal CMP apparatus.

(c) Etching step

In the above polishing step, the siliceous film formed on the substrate-surface from the siliceous film-forming composition is almost removed. However, for removing the residual siliceous film, etching treatment is preferably performed. In the etching treatment, etching solution is generally used. There is no particular restriction on the etching solution as long as it can remove the residual siliceous film. The etching solution is normally a hydrofluoric acid aqueous solution containing ammonium fluoride. The content of ammonium fluoride in the solution is preferably 5% or more, more preferably 30% or more.

In a trench isolation structure fabricated by a conventional process, the siliceous film often has such position-dependent properties that the properties in the trenches are different from those out of the trenches. Accordingly, when the substrate having that structure is subjected to etching or polishing, the film over a trench shows a dent and influences to deteriorate the quality of the resultant product. On the other hand, however, in a trench isolation structure fabricated by the process of the present invention, the siliceous film has such homogeneous properties that the product having desired performance can be obtained.

<u>Substrate with siliceous film</u>

A substrate with a siliceous film can be produced by the siliceous film-formation process of the present invention, which is explained above, in the case of the trench isolation structure fabrication. The substrate with a siliceous film is produced by coating with the siliceous film-forming composition having a small thickness shrinkage ratio. The derived siliceous film has homogeneous density, even in the trenches, particularly even at the bottoms of the fine trenches results in that the mechanical strength of the film is also homogeneous and that the homogeneity and flatness of the film are kept after the process of etching and polishing. Consequently, a product having high quality can be obtained.

Synthesis Example 1

To 5 kg of dehydrated pyridine kept at 0°C, 404 g of dichlorosilane (purity: 99% or more) was added with stirring. Successively, 59 g of hexachlorodisilane was added with stirring. While the obtained mixture was kept at 0°C, 298 L of ammonia gas (purity: 99.9%) was blown into the mixture with stirring.

While the temperature was kept at 0°C, the mixture was kept stirred for 12 hours to conduct the reaction. Thereafter, dried nitrogen was blown into the mixture for 30 minutes to remove excess ammonia to obtain a reaction solution in the form of slurry. The slurry was filtered to remove ammonium chloride, and the filtrate was mixed with xylene. The obtained mixture was heated at 50°C, and distilled under reduced pressure of 20 mmHg to remove pyridine. Thus, a 20 wt.% solution containing the polymer having a weight average molecular weight of 2000 was obtained. The solution was filtered through a filter (pore size: 0.1 μm) to obtain a polymer solution. The polymer was evaluated by means of DEPT-$^{29}$Si-NMR, to detect quaternary silicon atoms. The number of the quaternary silicon atoms was 70 atom% based on the number of all the silicon atoms contained in the polymer. Further, it was confirmed that the polymer contained no Si-Si bond, and accordingly that the bonds of the quaternary silicon atom were connected to nitrogen atoms.

Example 1

The polymer solution prepared in Synthesis Example 1 was spin-coated on a bare silicon substrate under the conditions of rotation speed: 1000 rpm and rotation time: 20 seconds, to form a coating film of 0.6 μm thickness. The coated substrate was pre-baked on a hot-plate at 150°C for 3 minutes, and successively placed without cooled in a hardening furnace under pure oxygen atmosphere. The temperature in the furnace was elevated at the rate of 10°C/minute to 700°C, and the substrate was heated for 30 minutes under oxygen atmosphere containing 80% water vapor to harden the film. Thus, a siliceous film was formed.

The hardened film thus obtained was measured by FTIR. As a result, the absorption assigned to Si-O bond was observed at 1080 $cm^{-1}$, and thereby it was confirmed to form a siliceous film. On the other hand, however, the absorptions assigned to N-H bond and Si-H bond at 3380 $cm^{-1}$ and 2200 $cm^{-1}$, respectively, were not observed, and thereby it was confirmed that polysilazane was converted into silicon dioxide (silica). Further, the stress of the film was measured with a stress meter, and evaluated based on that of the substrate before coating, and consequently found to be 31 MPa. Furthermore, the film was etched at 23°C with the use of an aqueous solution containing 0.5 wt.% hydrofluoric acid and 30 wt.% ammonium fluoride as an etching solution, to find that the relative etching rate of the film was 1.56 based on the etching rate of a thermally oxidized silica film.

Example 2

A TEG substrate provided with trenches of 0.05 μm, 0.1 μm, 0.2 μm, 0.5 μm and 1.0 μm widths and covered with a silicon nitride-liner layer was prepared. On the surface of this substrate, a siliceous film was formed in the same manner as in Example 1. Thereafter, the TEG substrate was cut perpendicularly to the longitudinal direction of the trenches, and then immersed for 30 seconds in an aqueous solution containing 0.5 wt.% hydrofluoric acid and 5 wt.% ammonium fluoride, followed by washing sufficiently with pure water and by drying.

The cross section of the TEG substrate was observed by scanning electron microscopy at a magnification of × 50000. The microscope was positioned that the observed direction was at an elevation angle of 30° to perpendicular plane of the cross section. Thus, the deepest part in each trench was observed to evaluate the etched amount. As a result, it was confirmed that the etched amount scarcely depended on the width of the trench and that the dense siliceous film was sufficiently formed even at the deepest place in the trench of 0.05 μm width.

Synthesis Example 2

The procedure of Synthesis Example 1 was repeated except for not using hexachlorodisilane, to prepare a perhydropolysilazane solution. The obtained polysilazane was measured, but no quaternary silicon atom was detected.

Comparative Example 1

The procedure of Example 1 was repeated except for using the perhydropolysilazane solution prepared in Synthesis Example 2, to form a siliceous film. With respect to the formed film, the film stress and the relative etching rate based on the etching rate of the thermally oxidized film were measured in the same manner as in Example 1 to find 143 MPa and 1.62, respectively.

Comparative Example 2

The procedure of Example 1 was repeated except for using the perhydropolysilazane solution prepared in Synthesis Example 2, to form a siliceous film on a TEG substrate. With respect to the formed film, the etched amount at the deepest part in each trench was evaluated in the same manner as in Example 2. As a result, it was found that the etched amount more largely depended upon the width of the trench than that in Example 2.

Synthesis Example 3 (Reference Example)

To 500 g of dehydrated xylene, 7 g of solid sodium (purity: 99% or more) was added. Further, 30 g of dichlorosilane (purity: 99% or more) was added with stirring at room temperature. Thereafter, while the reaction solution was kept at 90°C, the reaction was made to proceed for 10 hours to synthesize 1,2-dichlorodisilane (Wultz coupling).

In another reaction vessel, 4 kg of dehydrated pyridine was kept at 0°C. While the temperature was kept, 303 g of dichlorosilane (purity: 99% or more) was added with stirring. Successively, while the temperature was still kept at 0°C, the above-prepared solution containing 1,2-dichlorodisilane was added with stirring. Further, while the obtained mixture was yet kept at 0°C, 224 L of ammonia (purity: 99% or more) was blown into the mixture with stirring. The solution was kept stirred at 0°C for 12 hours, and thereby the reaction was made to proceed. Thereafter, dried nitrogen was blown into the mixture for 30 minutes to remove excess ammonia to obtain a reaction solution in the form of slurry. The slurry was filtered to remove ammonium chloride.

The obtained filtrate was mixed with xylene, and heated at 50°C, and distilled under reduced pressure of 20 mmHg to remove a portion of pyridine. Thus, a 20 wt.% polymer solution was obtained. The solution was filtered through a filter (pore size: 0.1 μm). The obtained polymer had a weight average molecular weight of 3500. The polymer was evaluated by means of DEPT-$^{29}$Si-NMR, to detect quaternary silicon atoms.

Example 3 (Reference Example)

The polymer solution prepared in Synthesis Example 3 was spin-coated on the TEG silicon substrate used in Example 2 under the conditions of rotation speed: 1000 rpm and rotation time: 20 seconds. A film formed on a bare silicon substrate under the same conditions had a thickness of 0.6 μm.

The coated substrate was pre-baked on a hot-plate at 150°C for 3 minutes.

After pre-baked, the substrate was placed while kept at 200°C in a hardening furnace under pure oxygen atmosphere. The temperature in the furnace was elevated at the rate of 10°C/minute to 400°C, and the substrate was heated for 30 minutes under oxygen atmosphere containing 80% water vapor to harden the film. Thus, a siliceous film was formed.

The thus-treated TEG substrate was cut perpendicularly to the longitudinal direction of the trenches, and then immersed for 30 seconds at 23°C in an aqueous solution containing 0.5 wt.% hydrofluoric acid and 5 wt.% ammonium fluoride, followed by washing sufficiently with pure water and by drying.

The cross section of the TEG substrate was observed by scanning electron microscopy at a magnification of × 50000. The microscope was positioned that the observed direction was at an elevation angle of 30° to perpendicular plane of the cross section. Thus, the deepest part in each trench was observed to evaluate the homogeneity of the film. As a result, it was confirmed that the etched amount at the bottom of the trench was small even if the width of the trench changed and hence that the trenches were homogeneously filled with the siliceous film.

Comparative Example 3 (Reference Example)

The procedure of Example 3 was repeated except that the polymer solution was replaced with a solution of polysilazane synthesized by the conventional method, to evaluate the film. As a result, it was found that the film formed from the polysilazane synthesized by the conventional method was etched in a relatively large amount at the bottom of the trench, and hence that the homogeneity of the film was inferior to that in Example 3.

Example 4 (Reference Example)

The procedure of Example 3 was repeated except that the substrate was replaced with a bare silicon substrate, to produce a substrate with a siliceous film.

The hardened film obtained was measured by FTIR. As a result, the absorption assigned to Si-O bond was observed at 1080 $cm^{-1}$, and thereby it was confirmed to form a siliceous film. On the other hand, however, the absorptions assigned to N-H bond and Si-H bond at 3380 $cm^{-1}$ and 2200 $cm^{-1}$, respectively, were not observed, and thereby it was confirmed that the polysilazane was converted into silicon dioxide (silica).

Further, the thickness of the siliceous film was measured by means of an ellipsometer. From the thus-obtained thickness and the thickness after the pre-bake step, the thickness shrinkage ratio was calculated according to the following formula:

$$(\text{thickness shrinkage ratio } (\%)) = [\{(\text{thickness after pre-baking}) - (\text{thickness after hardening})\} / (\text{thickness after pre-baking})] \times 100$$

The thickness shrinkage ratio calculated was 11.5%.

Comparative Example 4 (Reference Example)

The procedure of Example 4 was repeated except that the polymer solution was replaced with a solution of polysilazane synthesized by the conventional method, to calculate the thickness shrinkage ratio. As a result, the thickness shrinkage ratio was found to be 16.7%, which was larger than that in the case where the quaternary silicon atom-containing polysilazane was used.

Synthesis Example 4 (Reference Example)

To 1 kg of dehydrated xylene, 23 g of solid sodium (purity: 99% or more) was added. Further, 101 g of dichlorosilane (purity: 99% or more) was added with stirring at room temperature. Thereafter, while the reaction solution was kept at 90°C, the reaction was made to proceed for 10 hours to synthesize 1,2-dichlorodisilane (Wultz coupling).

In another reaction vessel, 4 kg of dehydrated pyridine was kept at 0°C. While the temperature was kept, the above-prepared solution containing 1,2-dichlorodisilane was added with stirring. Further, while the obtained mixture was still kept at 0°C, 81 L of ammonia (purity: 99% or more) was blown into the mixture with stirring. The solution was kept stirred at 0°C for 12 hours, and thereby the reaction was made to proceed. Thereafter, dried nitrogen was blown into the mixture for 30 minutes to remove excess ammonia. The thus-obtained polymer had a weight average molecular weight of 3500. The polymer was evaluated by means of DEPT-$^{29}$Si-NMR, to detect quaternary silicon atoms.

Example 5 (Reference Example)

The polymer solution prepared in Synthesis Example 4 was mixed with xylene, and heated at 50°C. The mixture was distilled under reduced pressure of 20 mmHg to remove a portion of pyridine. Thus, a 20 wt.% xylene solution containing the polymer was obtained In the polymer, the number of the quaternary silicon atoms was 70 atom% based on the number of all the silicon atoms contained therein.

Example 6 (Reference Example)

The polymer solution prepared in Synthesis Example 4 and a solution of polysilazane synthesized by the conventional method were mixed in various ratios. Each of the thus-prepared mixed solutions was spin-coated on a bare silicon substrate under the conditions of rotation speed: 1000 rpm and rotation time: 20 seconds, to form a coating film of 0.6 μm thickness. Each coated substrate was pre-baked on a hot-plate at 150°C for 3 minutes, and successively placed without cooled in a hardening furnace under pure oxygen atmosphere. The temperature in the furnace was elevated at the rate of 10°C/minute to 700°C, and the substrate was heated for 30 minutes under oxygen atmosphere containing 80% water vapor to harden the film. Thus, plural siliceous films having different polysilazane contents were formed.

The thickness shrinkage ratio of each siliceous film was measured, and found that the thickness shrinkage ratio changed in accordance with the polysilazane content. When the polymer of Synthesis Example 4 and the conventional polysilazane were mixed in the relative amounts of 100% and 20%, respectively, the lowest thickness shrinkage ratio was obtained. That was 15.0%.

Further, the cross section of the TEG substrate was observed by scanning electron microscopy at a magnification of × 50000. The microscope was positioned that the observed direction was at an elevation angle of 30° to perpendicular plane of the cross section. Thus, the deepest part in each trench was observed to evaluate the homogeneity of the film. As a result, it was confirmed that the etched amount scarcely depended on the width of the trench and hence that the dense siliceous film was sufficiently formed even at the deepest place in the trench of 0.05 μm width.

## Claims

1. A siliceous film-forming composition containing a polysilazane compound which comprises a quaternary silicon atom the four bonds of which are all connected to non-hydrogen atoms, and which is obtained by co-ammonolysis of one or a combination of two or more halosilane compounds represented by the formula (A):

$$X\text{-}(SiY_2)_n\text{-}X \qquad (A)$$

in which X is a halogen, Y is a halogen, provided that each X and each Y may be the same or different from each other, and n is a number of 2 or more; and a solvent capable of dissolving said polysilazane compound.

2. The siliceous film-forming composition according to claim 1, wherein said polysilazane compound is obtained by co-ammonolysis of dichloromonosilane in combination with one or more halosilane compounds represented by the formula (A) other than dichloromonosilane.

3. The siliceous film-forming composition according to claim 1 or 2, wherein the number of said quaternary silicon atoms contained in said polysilazane compound is 30 atom% or more based on the number of all the silicon atoms contained therein.

4. The siliceous film-forming composition according to any of claims 1 to 3, **characterized by** further containing a polysilazane compound other than said polysilazane compound.

5. The siliceous film-forming composition according to any of claims 1 to 3, **characterized by** further containing a polysilazane compound represented by the formula (I):

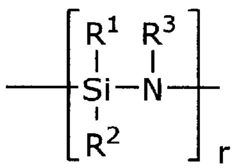

(I)

in which each of $R^1$ to $R^3$ is independently hydrogen, an alkyl group containing 1 to 3 carbon atoms, or a substituted or non-substituted phenyl group; and r is an integer indicating polymerization degree.

6. A siliceous film-formation process comprising a coating step in which a concave-convex surface of a silicon substrate is coated with the siliceous film-forming composition according to any of claims 1 to 5, and a hardening step in which the coated substrate is subjected to heating treatment at a temperature of less than 1000°C under an oxygen atmosphere or under an oxidizing atmosphere containing water vapor, so that said composition is converted into silicon dioxide in the form of a film.

7. The use of a composition containing a polysilazane compound which comprises a quaternary silicon atom the four bonds of which are all connected to non-hydrogen atoms, and which is obtained by co-ammonolysis of one or a combination of two or more halosilane compounds represented by the formula (A):

$$X\text{-}(SiY_2)_n\text{-}X \qquad (A)$$

in which X is a halogen, Y is a halogen , provided that each X and each Y may be the same or different from each other, and n is a number of 2 or more; and a solvent capable of dissolving said polysilazane compound, for forming a siliceous film.

8. The use according to claim 7, wherein said polysilazane compound is obtained by co-ammonolysis of dichloromonosilane in combination with one or more halosilane compounds represented by the formula (A) other than dichloromonosilane.

9. The use according to claim 7 or 8, wherein the number of said quaternary silicon atoms contained in said polysilazane compound is 30 atom% or more based on the number of all the silicon atoms contained therein.

**10.** The use according to any of claims 7 to 9, **characterized by** the composition further containing a polysilazane compound other than said polysilazane compound.

**11.** The use according to any of claims 7 to 9, **characterized by** the composition further containing a polysilazane compound represented by the formula (I):

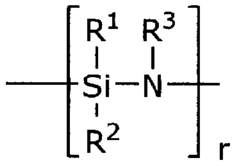

(I)

in which each of $R^1$ to $R^3$ is independently hydrogen, an alkyl group containing 1 to 3 carbon atoms, or a substituted or non-substituted phenyl group; and r is an integer indicating polymerization degree.

**Patentansprüche**

**1.** Eine Silizium-haltige filmbildende Zusammensetzung, enthaltend eine Polysilazan-Verbindung, welche ein quartäres Siliziumatom enthält, dessen vier Bindungen alle an nicht-Wasserstoffatome gebunden sind, und welche durch Co-Ammonolyse von einer oder einer Kombination von zwei oder mehr Halosilanverbindungen, dargestellt durch die Formel (A), erhalten wird:

$$X\text{-}(SiY_2)_n\text{-}X \qquad (A)$$

in welcher X ein Halogen ist, Y ein Halogen ist, vorausgesetzt, dass jedes X und jedes Y das gleiche oder verschieden voneinander sein können, und n eine Zahl von 2 oder mehr ist; und ein Lösungsmittel, fähig die Silazan-Verbindung zu lösen.

**2.** Silizium-haltige filmbildende Zusammensetzung gemäß Anspruch 1, wobei die Polysilazan-Verbindung durch Co-Ammonolyse von Dichlormonosilan in Verbindung mit einer oder mehreren von Dichlormonosilan verschiedenen Halosilan-Verbindungen, dargestellt durch die Formel (A), erhalten wird.

**3.** Silizium-haltige filmbildende Zusammensetzung gemäß Anspruch 1 oder 2, wobei die Anzahl der in der Polysilazan-Verbindung enthaltenen quartären Siliziumatome 30 Atom% oder mehr, basierend auf der Anzahl aller darin enthaltenden Siliziumatome, beträgt.

**4.** Silizium-haltige filmbildende Zusammensetzung gemäß einem der Ansprüche 1 bis 3, dadurch charakterisiert, dass ferner eine von der Polysilazan-Verbindung verschiedene Polysilazan-Verbindung enthalten ist.

**5.** Silizium-haltige filmbildende Zusammensetzung gemäß einem der Ansprüche 1 bis 3, dadurch charakterisiert, dass ferner eine Polysilazan-Verbindung, dargestellt durch die Formel (I), enthalten ist:

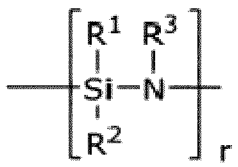

(I)

in welcher jedes von $R^1$ bis $R^3$ unabhängig Wasserstoff, eine Alkylgruppe, enthaltend 1 bis 3 Kohlenstoffatome oder eine substituierte oder nicht-substituierte Phenylgruppe ist; und r eine Zahl ist, welche den Polymerisationsgrad angibt.

**6.** Verfahren zum Bilden eines Silizium-haltigen Films umfassend einen Beschichtungsschritt, in welchem eine konkav-konvexe Oberfläche eines Siliziumsubstrates mit der Silizium-haltigen filmbildenden Zusammensetzung gemäß einem der Ansprüche 1 bis 5 beschichtet wird, und einen Härtungsschritt, in welchem das beschichtete Substrat

einer thermischen Behandlung bei einer Temperatur von weniger als 1000°C unter einer Sauerstoffatmosphäre oder unter einer oxidierenden Atmosphäre umfassend Wassersdampf, unterzogen wird, so dass die Zusammensetzung in Siliziumdioxid in Form eines Films umgewandelt wird.

**7.** Verwendung einer Zusammensetzung umfassend eine Polysilazan-Verbindung, welche ein quartäres Siliziumatom enthält, dessen vier Bindungen alle an nicht-Wasserstoffatome gebunden sind, und welche durch Co-Ammonolyse von einer oder einer Kombination von zwei oder mehr Halosilan-Verbindungen, dargestellt durch die Formel (A), erhalten wird:

$$X\text{-}(SiY_2)_n\text{-}X \qquad (A)$$

in welcher X ein Halogen ist, Y ein Halogen ist, vorausgesetzt dass jedes X und jedes Y das gleiche oder verschieden voneinander sein können, und n eine Zahl von 2 oder mehr ist; und ein Lösungsmittel, fähig die Silazan-Verbindung zu lösen, um einen Siliziumfilm zu bilden.

**8.** Verwendung gemäß Anspruch 7, wobei die Polysilazan-Verbindung durch Co-Ammonolyse von Dichlormonosilan in Verbindung mit einer oder mehreren von Dichlormonosilan verschiedenen Halosilan-Verbindungen, dargestellt durch die Formel (A), erhalten wird.

**9.** Verwendung gemäß Anspruch 7 oder 8, wobei die Anzahl der in der Polysilazan-Verbindung enthaltenen quartären Siliziumatome 30 Atom% oder mehr, basierend auf der Anzahl aller darin enthaltenden Siliziumatome, beträgt.

**10.** Verwendung gemäß einem der Ansprüche 7 bis 9, dadurch charakterisiert, dass ferner eine von der Polysilazan-Verbindung verschiedene Polysilazan-Verbindung enthalten ist.

**11.** Verwendung gemäß einem der Ansprüche 7 bis 9, dadurch charakterisiert, dass ferner eine Polysilazan-Verbindung, dargestellt durch die Formel (I), enthalten ist:

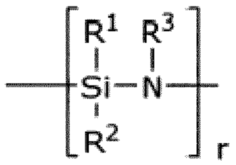

(I)

in welcher jedes von $R^1$ bis $R^3$ unabhängig Wasserstoff, eine Alkylgruppe, enthaltend 1 bis 3 Kohlenstoffatome oder eine substituierte oder nicht-substituierte Phenylgruppe ist; und r eine Zahl ist, welche den Polymerisationsgrad angibt.

## Revendications

**1.** Composition de formation de film siliceux contenant un composé polysilazane qui comprend un atome de silicium quaternaire dont les quatre liaisons sont toutes reliées à des atomes qui ne sont pas des atomes d'hydrogène et qui est obtenu par co-ammoniolyse d'un composé halogénosilane représenté par la formule (A) ou d'une association de deux ou plus de deux composés halogénosilanes représentés par cette formule :

$$X\text{-}(SiY_2)_n\text{-}X \qquad (A)$$

dans laquelle X est un halogène, Y est un halogène, à condition que chaque X et chaque Y puissent être identiques ou différents l'un de l'autre, et n est un nombre supérieur ou égal à 2 ; et un solvant capable de dissoudre ledit composé polysilazane.

**2.** Composition de formation de film siliceux selon la revendication 1, dans laquelle ledit composé polysilazane est obtenu par co-ammoniolyse de dichloromonosilane en association avec un ou plusieurs composés halogénosilanes représentés par la formule (A) autres que le dichloromonosilane.

**3.** Composition de formation de film siliceux selon la revendication 1 ou 2, dans laquelle le nombre desdits atomes de

silicium quaternaires contenus dans ledit composé polysilazane est supérieur ou égal à 30 % at. par rapport au nombre de tous les atomes de silicium contenus dans celui-ci.

**4.** Composition de formation de film siliceux selon l'une quelconque des revendications 1 à 3, **caractérisée en ce qu'**elle contient en outre un composé polysilazane autre que ledit composé polysilazane.

**5.** Composition de formation de film siliceux selon l'une quelconque des revendications 1 à 3, **caractérisée en ce qu'**elle contient en outre un composé polysilazane représenté par la formule (I) :

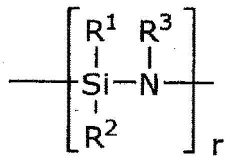

(I)

dans laquelle chacun de $R^1$ à $R^3$ est indépendamment l'hydrogène, un groupe alkyle contenant 1 à 3 atomes de carbone ou un groupe phényle substitué ou non substitué ; et r est un nombre entier indiquant le degré de polymérisation.

**6.** Procédé de formation de film siliceux comprenant une étape d'enduction dans laquelle une surface concave-convexe d'un substrat en silicium est enduite de la composition de formation de film siliceux selon l'une quelconque des revendications 1 à 5 et une étape de durcissement dans laquelle le substrat enduit est soumis à un traitement de chauffage à une température inférieure à 1000 °C sous une atmosphère d'oxygène ou sous une atmosphère oxydante contenant de la vapeur d'eau, pour que ladite composition soit convertie en dioxyde de silicium sous la forme d'un film.

**7.** Utilisation d'une composition contenant un composé polysilazane qui comprend un atome de silicium quaternaire dont les quatre liaisons sont toutes reliées à des atomes qui ne sont pas des atomes d'hydrogène et qui est obtenu par co-ammoniolyse d'un composé halogénosilane représenté par la formule (A) ou d'une association de deux ou plus de deux composés halogénosilanes représentés par cette formule :

$$X\text{-}(SiY_2)_n\text{-}X \qquad (A)$$

dans laquelle X est un halogène, Y est un halogène, à condition que chaque X et chaque Y puissent être identiques ou différents l'un de l'autre, et n est un nombre supérieur ou égal à 2 ; et un solvant capable de dissoudre ledit composé polysilazane, pour la formation d'un film siliceux.

**8.** Utilisation selon la revendication 7, dans laquelle ledit composé polysilazane est obtenu par co-ammoniolyse de dichloromonosilane en association avec un ou plusieurs composés halogénosilanes représentés par la formule (A) autres que le dichloromonosilane.

**9.** Utilisation selon la revendication 7 ou 8, dans laquelle le nombre desdits atomes de silicium quaternaires contenus dans ledit composé polysilazane est supérieur ou égal à 30 % at. par rapport au nombre de tous les atomes de silicium contenus dans celui-ci.

**10.** Utilisation selon l'une quelconque des revendications 7 à 9, **caractérisée en ce que** la composition contient en outre un composé polysilazane autre que ledit composé polysilazane.

**11.** Utilisation selon l'une quelconque des revendications 7 à 9, **caractérisée en ce que** la composition contient en outre un composé polysilazane représenté par la formule (I) :

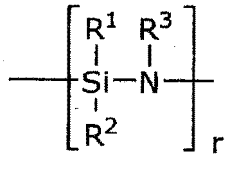

(I)

dans laquelle chacun de $R^1$ à $R^3$ est indépendamment l'hydrogène, un groupe alkyle contenant 1 à 3 atomes de carbone ou un groupe phényle substitué ou non substitué ; et r est un nombre entier indiquant le degré de polymérisation.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 3178412 B
- JP 2001308090 A
- JP 2005120029 A
- EP 0237199 A2
- US 4870778 A
- WO 03045959 A


### Non-patent literature cited in the description


- **CHEN X. et al.** Journal of Applied Physis. American Institute of Physics, 2004, vol. 97, 14913